# EUROPÄISCHE PATENTANMELDUNG

(11) **EP 1 352 989 A1**
(43) Veröffentlichungstag der Anmeldung: **15.10.2003**
(21) Anmeldenummer: 02008045.3
(22) Anmeldetag: 10.04.2002
(51) Int. Cl.: C23C 16/04, C23C 10/04, C23C 8/04, C23C 4/00

(54) **Bauteil mit einer Maskierungsschicht**

(71) Anmelder: SIEMENS AKTIENGESELLSCHAFT, 80333 München (DE)
(72) Erfinder: Cox, Nigel-Philip, 10119 Berlin (DE); Dernovsek, Oliver, 81669 Muenchen (DE); Reiche, Ralph, 13465 Berlin (DE)

(57) **Zusammenfassung**

Maskierungsschichten für Bauteile nach dem Stand der Technik reagieren mit dem Grundmaterial des Bauteils bzw. lassen sich schlecht wieder entfernen.

Das erfindungsgemäße Bauteil weist eine Maskierungsschicht (25) auf, die sich nach einer Beschichtung der Bauteil (1) sehr leicht entfernen lässt, weil zum einen keine gute Haftung zwischen der Maskierungsschicht (25) und dem Grundmaterial (40) des Bauteils (1) gegeben ist oder die Maskierungsschicht (25) sich durch Eindringen einer Flüssigkeit leicht entfernen lässt.

## Beschreibung

Die Erfindung betrifft ein Bauteil nach dem Gattungsbegriff des Anspruchs 1 und 3.

Bauteile wie z.B. Turbinenschaufeln, insbesondere für Gasturbinen, werden insbesondere im Schaufelblattbereich beschichtet, weil diese hohen thermischen Belastungen ausgesetzt sind.
Im Sockel- bzw. im Befestigungsbereich der Turbinenschaufel herrschen niedrigere Temperaturen, so dass dort keine Beschichtung in Form einer Wärmedämmschicht notwendig ist. Keramische Beschichtungen sind in diesem Bereich sogar unerwünscht, weil der Sockel genau in eine metallische Scheibe eingepasst werden muss.

Maskierungen nach dem Stand der Technik, die eine Beschichtung verhindern sollen, lassen sich oft schlecht wieder entfernen, da eine gute Haftung des Materials der Maskierung mit dem Grundmaterial der Turbinenschaufel gegeben ist oder eine unerwünschte Diffusion von Elementen aus der Maskierungsschicht in das Grundmaterial der Turbinenschaufel erfolgt.

Aufgabe der Erfindung ist es daher, eine Maskierungsschicht aufzuzeigen, die sich nach einer gewollten Beschichtung der Turbinenschaufel in den unerwünschten Bereichen wieder leicht entfernen lässt, ohne dass es zu einer Beeinflussung des Grundmaterials oder der Geometrie der Turbinenschaufel in dem maskierten Bereich kommt.

Die Aufgabe wird gelöst durch eine Turbinenschaufel gemäß Anspruch 1. Dabei wird eine Keramik direkt auf das Grundmaterial der Turbinenschaufel aufgebracht.

Wärmedämmschichten, die auf eine Turbinenschaufel im Schaufelblattbereich aufgebracht werden, weisen in der Regel zwischenliegende Schichten zwischen einem Substrat, d.h. dem Grundmaterial der Turbinenschaufel, und der Wärmedämmschicht auf, wie z.B. sogenannte Haftmittlerschichten, beispielsweise metallisches MCrAlY, oder Diffusionsbarrieren.
Bei der Maskierung wird auf diese Zwischenschichten verzichtet um eine gute Anbindung der Maskierungsschicht zu verhindern. Die Maskierungsschicht ist insbesondere aus Keramik, weil sich die spröde Keramik durch einfache Verfahren, wie z.B. Sandstrahlen, Trockeneisstrahlen entfernen lässt. Das Material für die Keramik wird so gewählt, dass keine oder kaum Diffusion aus der Keramik heraus in das Substrat stattfindet.

Die Aufgabe der Erfindung wird weiterhin durch eine Turbinenschaufel gemäß Anspruch 3 gelöst. Dabei reagiert die Maskierungsschicht mit dem Material des aufzubringenden Materials und lässt sich so leicht entfernen.

Weitere vorteilhafte Ausbildungen des erfindungsgemäßen Bauteils gemäß Anspruch 1 bzw. 3 sind in den Unteransprüchen 2, bzw. 4 bis 14 aufgelistet.

Es zeigen
Figur 1 eine Turbinenschaufel nach dem Stand der Technik, Figur 2 Verfahrensschritte zur Herstellung einer Beschichtung nach dem Stand der Technik,
Figur 3 eine Maskierungsschicht einer erfindungsgemäßen Turbinenschaufel,
Figur 4 eine weitere Maskierungsschicht einer erfindungsgemäßen Turbinenschaufel,
Figur 5, 6 zeigen eine Maskierungsschicht, die mit Material aufzubringender Schichten reagiert, und
Figur 7, 8 wie sich die Maskierungsschicht nach einer Reaktion wieder leicht entfernen lässt.

Gleiche Bezugszeichen haben in den verschiedenen Figuren die gleiche Bedeutung.

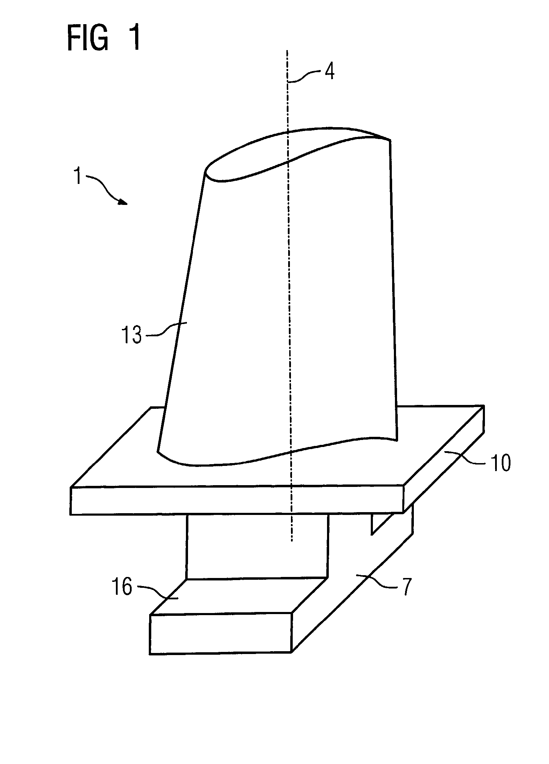

Figur 1 zeigt in perspektivischer Ansicht eine Turbinenschaufel 1, insbesondere eine Laufschaufel für eine Gasturbine, die sich entlang einer Längsachse 4 erstreckt. Die Turbinenschaufel 1 weist entlang der Längsachse 4 aufeinanderfolgend einen Befestigungsbereich 7, eine daran angrenzende Schaufelplattform 10 sowie einen Schaufelblattbereich 13 auf.
Der Befestigungsbereich 7 ist als ein Schaufelfuß 16 ausgebildet, der zur Befestigung der Turbinenschaufel 1 an einer nicht näher dargestellten Welle einer ebenfalls nicht dargestellten Strömungsmaschine dient. Der Schaufelfuß 16 ist beispielsweise als Hammerkopf ausgestaltet. Andere Ausgestaltungen, beispielsweise als Tannenbaum- oder Schwalbenschwanzfuß sind möglich.

Bei herkömmlichen Turbinenschaufeln 1 werden in allen Bereichen der Turbinenschaufel massive metallische Werkstoffe, insbesondere Nickel- oder Cobalt-basierte Superlegierungen, verwendet. Die Turbinenschaufel kann hierbei durch ein Gussverfahren, durch ein Schmiedeverfahren, durch ein Fräsverfahren oder Kombinationen daraus gefertigt sein.

Insbesondere der Befestigungsbereich 7 ist aus Metall, weil der passgenau in eine entsprechende Form einer Scheibe eingeklemmt wird. Spröde keramische Beschichtungen würden dabei abplatzen und die Geometrie im Befestigungsbereich verändern.

Der Schaufelblattbereich 13 ist beispielsweise mit einer Wärmedämmschicht beschichtet, wobei zwischen dem Grundmaterial der Turbinenschaufel 1 beispielsweise noch weitere Schichten, wie z.B. Haftvermittlerschichten (MCrAlY-Schichten) angeordnet sein können.

Ein erfindungsgemäßes Bauteil in Form einer Turbinenschaufel 1 kann eine Leit- oder Laufschaufel einer beliebigen Turbine, insbesondere einer Dampf- oder Gasturbine, sein.

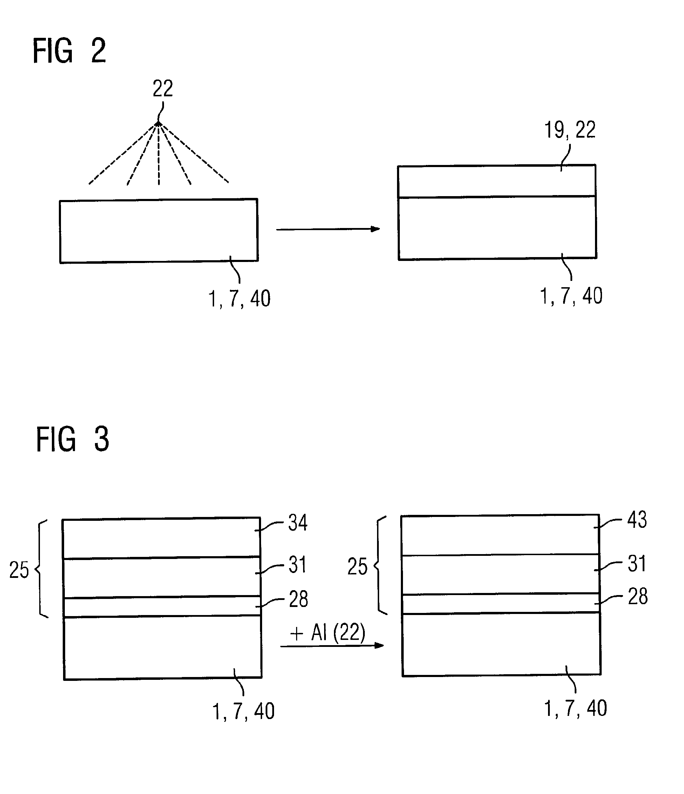

Figur 2 zeigt, was passiert, wenn die Oberfläche der Schaufel 1 keine Maskierungsschicht 25 (Fig. 3) aufweist. Das Material 22 einer Zwischenschicht 19 (MCrAlY), die beispielsweise durch Plasmaspritzen, durch PVD oder CVD oder Eintauchen in ein flüssiges Metall oder Aufbringen von Pulver in jeglicher Form auf eine Oberfläche der Turbinenschaufel 1 aufgebracht wurde und die Zwischenschicht 19 bildet, führt zu einer Reaktion des Materials 22 mit der Turbinenschaufel 1 und zu einer guten Haftung der Zwischenschicht 19 mit dem Grundmaterial der Turbinenschaufel 1.
Wenn die Zwischenschicht 19 wieder entfernt werden soll, weil sie bspw. im Befestigungsbereich 7 unerwünscht ist, so bereitet es daher große Probleme, weil sich die Geometrie des Befestigungsbereichs 7 durch teilweises Entfernen des Grundmaterials des Substrats 40 verändert.

Figur 3 zeigt ein erfindungsgemässes Bauteil in Form einer Turbinenschaufel 1 mit einer Maskierungsschicht 25.
Auf die Turbinenschaufel 1 wird bspw. zuerst eine erste Funktionsschicht 28 aufgebracht. Dies ist beispielsweise eine nanometerdünne Polycarbosilanschicht, die bei 200°C an Luft vernetzt und eine gute Haftung zum Grundmaterial 40 der Turbinenschaufel 1 ermöglicht.

Auf die erste Funktionsschicht 28 wird beispielsweise eine Gradientenschicht 31 aufgebracht, wobei das Material für die Gradientenschicht 31 eine Mischung aus Polysiloxan und einer Metallkeramik und/oder Metall ist.
Die Gradientenschicht 31 kann beispielsweise in Form eines Schlickers mit Schichtdicken von 10 - 30 µm Dicke aufgebracht werden und ebenfalls bei etwa 200°C an Luft vernetzt werden. Als metallischer Füllstoff wird diesem Material der Gradientenschicht 31 ein weiteres Pulver, insbesondere der Zusammensetzung MCrAlY, wobei M für Fe, Co, Ni steht, beigefügt, weil dieses aufgrund seines Ausdehnungskoeffizienten als Zwischenschicht (Haftvermittlerschicht) zwischen Grundmaterial 40 und keramischer Wärmedämmschicht verwendet wird.

Auf die Gradientenschicht wird eine Reaktivschicht 34 aufgebracht, wobei diese bspw. aus einem reinen Kohlenstoffprecursor besteht. Die Vernetzung innerhalb der Reaktivschicht 34 erfolgt bei 180°C an Luft.

Die vernetzen Schichten 28, 31, 34 werden durch eine thermische Behandlung bei 1000°C in Argonatmosphäre in eine Keramik umgewandelt, durch den sogenannten Pyrolyseprozess. Aufgrund der Dichteänderung des metallorganischen Precursors wie z.B. des Polysiloxans mit einer Dichte von 1 g/cm³ in eine Siliciumoxycabidphase (SiOC) mit einer Dichte von ca. 2,3 g/cm³, ist eine 10 - 30 µm dicke, dichte und rissfreie Beschichtung nicht möglich. Deshalb werden dem Polymer metallische oder keramische Füllstoffe beispielsweise mit einem Volumenanteil von 30 - 50% zugesetzt, um die stattfindende Phasenumwandlung des Polymers und die Rissbildung gezielt zu steuern und die thermomechanischen Spannungen aufgrund unterschiedlicher thermischer Ausdehnungskoeffizienten an der Grenzfläche zwischen Metall (Turbinenschaufel 1) und Maskierungsschicht 25 zu minimieren oder zu eliminieren.

Die geforderte Temperaturbeständigkeit der Markierungsschicht ist durch die thermische Phasentransformation des Polycarbosilans in die entsprechende hochtemperaturbeständige SiOC bzw. Graphitphase gegeben.

Während des Beschichtungsprozesses wird ein Material 22 auf den Schaufelblattbereich 13 der Turbinenschaufel 1 und auf die Maskierungsschicht 25 aufgebracht. Das Material 22 reagiert mit der Reaktivschicht 34 zu einer Reaktionsschicht 43, d.h. zu einem Material, das hochtemperaturbeständig ist, aber beispielsweise in Wasser löslich ist, also leicht entfernbar ist.

Das Material 22 ist beispielsweise Aluminium, das auf die Turbinensschaufel 1 aufgebracht wird, um eine Aluminidschicht zu bilden. Eine solche Aluminidschicht kann durch Plasmaspritzen oder Verfahren wie sie in dem EP-Patent 0 525 545 B1 und dem EP-Patent 0 861 919 B1 angegeben sind, aufgebracht werden.

Bei Aluminium reagiert der Kohlenstoff der Reaktivschicht 34 mit Aluminium zu Al₄C₃. Wenn der Schaufelblattbereich 13 vollständig beschichtet ist, kann die gesamte Schaufel insbesondere der Befestigungsbereich 7 in Wasser eingebracht werden, wodurch sich die mit dem Material 22 umgewandelte wasserlösliche Reaktionsschicht 43 auflöst.
Die unterliegenden Schichten 28, 31 lassen sich leicht durch Trockeneisstrahlen entfernen, so dass durch die Entfernungsverfahren keine Geometrieänderung im Befestigungsbereich 7 erfolgt.
Aluminium wird beispielsweise beim Refurbishment, d.h. u.a. beim Entfernen verbrauchter MCrAlY-Schichten, auf eine Turbinenschaufel 1 aufgebracht.

Statt des hier beispielsweise gezeigten dreischichtigen Aufbaus, kann die Maskierungsschicht 25 auch eine Gradientenschicht sein, die einen graduellen Aufbau aufweist, d.h. auf dem Substrat 40 ist die Zusammensetzung so gewählt, dass eine gute Haftung ermöglicht ist, und an der äußeren Oberfläche ist die Zusammensetzung so, dass diese mit dem Material 22 noch aufzubringender Schichten reagiert.

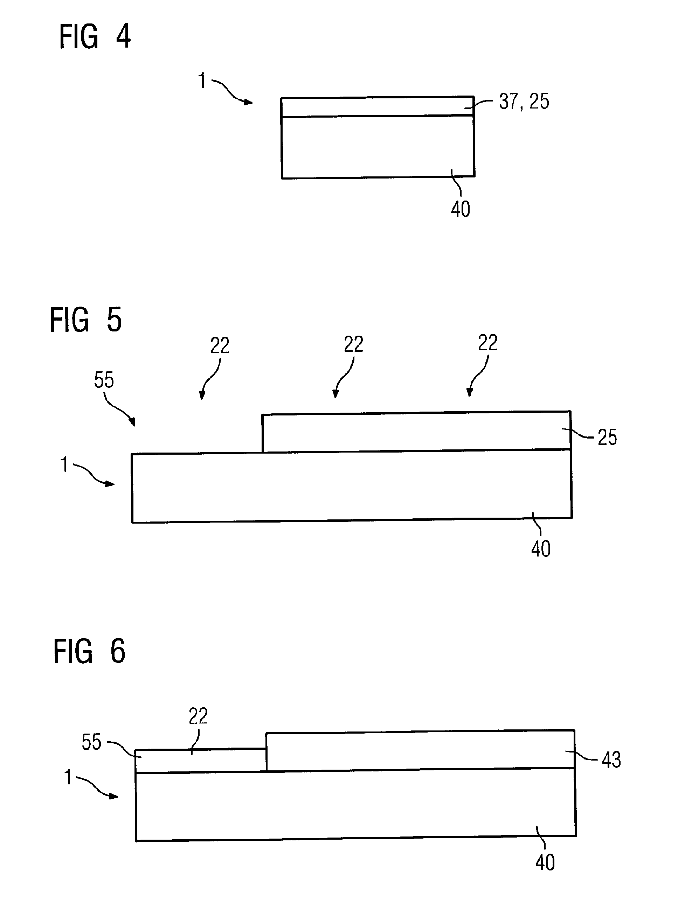

Figur 4 zeigt ein erfindungsgemäßes Bauteil in Form einer Turbinenschaufel 1 mit einer Maskierungsschicht 25.

Auf die beispielsweise metallische Turbinenschaufel 1 wird direkt eine keramische Schicht 37 aufgebracht, die die Maskierungsschicht 25 bildet. Dies kann bspw. eine Oxidkeramik, die dem thermischen Ausdehnungskoeffizienten des Substrats angepasst ist, sein.
Zwischen der keramischen Schicht 37 und dem metallischen Substrat 40 der Turbinenschaufel 1 sind keine weiteren Schichten, insbesondere keine Haftvermittlerschichten vorhanden, so dass sich durch leichten Energieeintrag, wie z.B. Sandstrahlen oder Trockeneisstrahlen, die keramische Schicht 25,37 entfernen lässt. Die dichte keramische Schicht 37 bildet auch während eines Beschichtungsverfahrens der Turbinenschaufel 1 mit verschiedenen Schichten, wie z.B. Haftvermittlerschichten oder Wärmedämmschichten, eine Diffusionsbarriere.

Die Maskierungsschicht 25 kann auch erst mit dem Material 22 noch aufzubringender Schichten beispielsweise zu einer spröden Schicht 43, beispielsweise einer keramischen Schicht 37 reagieren. Die keramische Schicht 37 kann sich beispielsweise auch erst nach einer weiteren Wärmebehandlung ausbilden (Pyrolyse).
Solche spröden Schichten 43 lassen sich durch einfache Verfahren wie Thermoschockverfahren oder Sandstrahlen oder Trockeneisstrahlen, d.h. durch Energie einbringende, aber nicht abrasiv wirkende Strahlverfahren entfernen.

Besonders vorteilhaft ist es, wenn die Maskierungsschicht 25 mit dem Material 22 aufzubringender Schichten zu einer wasserlöslichen Schicht 43 reagiert.

Dabei können unter der obersten Schicht der Maskierungsschicht weitere Schichten vorhanden sein, d.h. die Maskierungsschicht 25 kann mehrschichtig aufgebaut sein. Dabei gibt es die Möglichkeit, eine Anbindungsschicht direkt auf das Substrat 40 des beschichteten Bauteils aufzubringen und weiterhin eine Gradientenschicht aufzubringen, die eine Anpassung an thermische Ausdehnungskoeffizienten ermöglicht, so dass die Maskierungsschicht 25 auch während der Maskierung rissfrei bleibt, so dass kein Material auf das Substrat 40 des zu beschichtenden Bauteils gelangen kann.

Figur 5 zeigt eine Turbinenschaufel 1 mit einem Substrat 40, auf dem eine Maskierungsschicht 25 aufgebracht ist. Das Material der Maskierungsschicht reagiert und diffundiert nicht bei den höheren Temperaturen des Beschichtungsverfahrens mit dem Material des Substrats 40.

Während des Beschichtungsverfahrens trifft Material 22 auf die Maskierungsschicht 25 auf und reagiert mit dieser. Die Reaktion kann auch in einer nachgelagerten Wärmebehandlung stattfinden, wenn die Reaktionstemperatur höher liegt als die Substrattemperatur während der Beschichtung. Die so gebildete Reaktionsschicht 43 (Fig. 6) lässt sich nach dem Beschichtungsverfahren der Turbinenschaufel wieder leicht entfernen, weil sie beispielsweise spröde oder wasserlöslich ist. Das Material 22 trifft also auch auf die unmaskierten Bereiche des Substrats 40 der Turbinenschaufel 1 auf und bildet eine gewünschte Beschichtung 55 (Fig. 6).

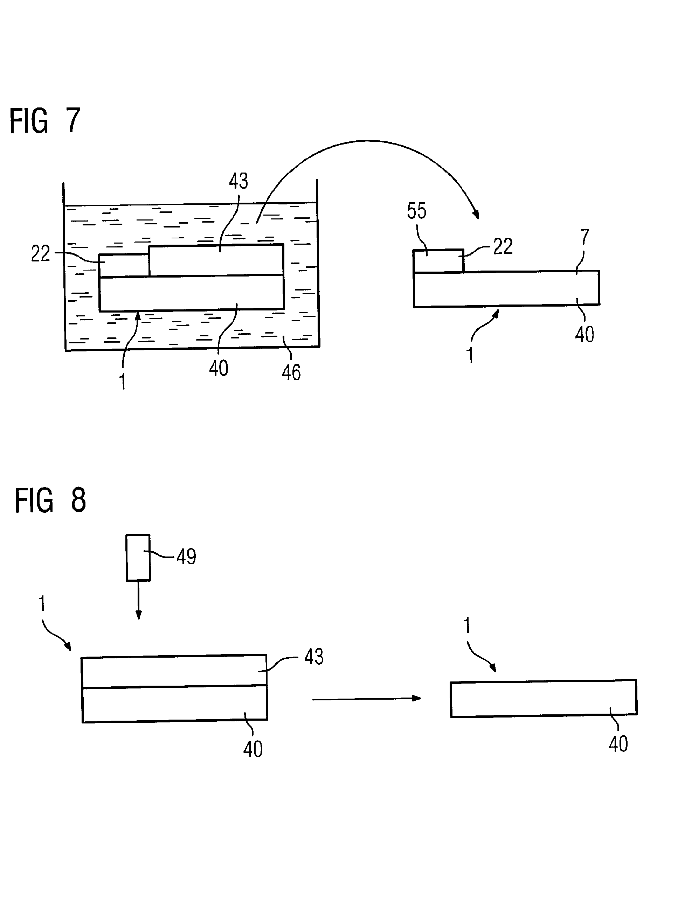

Figur 7 zeigt ein Wasserbad 46, in dem eine Turbinenschaufel mit einer wasserlöslichen Schicht 43 eingebracht ist. Durch die Wasserlöslichkeit lässt sich die Schicht 43 leicht entfernen, so dass nach Herausnahme der Turbinenschaufel 1 aus dem Wasserbad ein unbeschichteter Teil und ein gewünschter beschichteter Teil 55 der Turbinenschaufel 1 vorhanden ist. Die Reaktionsschicht 43 kann auch durch Wasserstrahlen entfernt werden, wobei da noch ein kleiner Energieeintrag vorhanden ist.

Ebenso kann die beispielsweise spröde Reaktionsschicht 43 durch einen Energieeintrag aus einer Bestrahlungskanone 49 (Ultraschall, Trockeneisstrahler, Sandstrahler) abgetragen werden. (Fig. 8)

## Patentansprüche

**1.** Für eine teilweise Beschichtung vorgesehenes Bauteil, insbesondere eine Turbinenschaufel,
das eine Maskierungsschicht auf Flächen des Bauteils aufweist, die nicht beschichtet werden sollen,
**dadurch gekennzeichnet, dass**
die Maskierungsschicht (25) aus Keramik (37) ist und direkt auf dem Grundmaterial (40) des Bauteils (1) aufliegt,
wobei keine oder nur eine geringe chemische Verbindung zwischen Maskierungsschicht (25) und dem Grundmaterial (40) des Bauteils (1) vorhanden ist,
so dass sich keine gute Haftung zwischen Maskierungsschicht (25) und Grundmaterial (40) ergibt.

**2.** Bauteil nach Anspruch 1,
**dadurch gekennzeichnet, dass**
die Keramik (37) eine Oxidkeramik ist.

**3.** Für eine teilweise Beschichtung vorgesehenes Bauteil, insbesondere eine Turbinenschaufel,
das eine Maskierungsschicht auf Flächen des Bauteils aufweist, die nicht beschichtet werden sollen,
**dadurch gekennzeichnet, dass**
die Maskierungsschicht (25) mit Material (22) auf das Bauteil (1) aufzubringender Schichten (19) reagiert und sich aufgrund der Reaktion zwischen diesem Material (22) und Material der Maskierungsschicht (25) wieder leicht entfernen lässt.

**4.** Bauteil nach Anspruch 3,
**dadurch gekennzeichnet, dass**
die Maskierungsschicht (25) mit dem Material (22) auf das Bauteil (1) aufzubringender Schichten (19) eine spröde Schicht (43) bildet.

**5.** Bauteil nach Anspruch 3 oder 4,
**dadurch gekennzeichnet, dass**
die Maskierungsschicht (25) mit dem Material (22) auf das Bauteil (1) aufzubringender Schichten (19) eine keramische Schicht oder eine Vorstufe zu einer keramischen Schicht (43) bildet.

**6.** Bauteil nach Anspruch 3,
**dadurch gekennzeichnet, dass**
die Maskierungsschicht (25) mit dem Material (22) auf das Bauteil (1) aufzubringender Schichten (19) eine wasserlösliche Schicht bildet.

**7.** Bauteil nach Anspruch 3,
**dadurch gekennzeichnet, dass**
auf ein Grundmaterial (40) des Bauteils (1) eine erste Funktionsschicht (28), als ein Teil der Maskierungsschicht (25), aufgebracht wird, die eine gute Haftung zum Grundmaterial des Bauteils (1) ermöglicht.

**8.** Bauteil nach Anspruch 7,
**dadurch gekennzeichnet, dass**
die erste Funktionsschicht (28) aus Carbosilan besteht.

**9.** Bauteil nach Anspruch 7,
**dadurch gekennzeichnet, dass**
eine Gradientenschicht (31) auf die erste Funktionsschicht (28) aufgebracht wird, die eine dichte und rissfreie Beschichtung der Maskierungsschicht (25) ermöglicht.

**10.** Bauteil nach Anspruch 9,
**dadurch gekennzeichnet, dass**
die Gradientenschicht (31) eine Mischung aus Polysiloxan, Metall und/oder einer Metallkeramik ist.

**11.** Bauteil nach Anspruch 10,
bei der der Gradientenschicht (31) ein Füllstoff zugesetzt ist, um thermomechanische Spannungen in der Maskierungsschicht (25) oder zwischen Maskierungsschicht (25) und einem Substrat (40) des Bauteils (1) aufgrund unterschiedlicher thermischer Ausdehnungskoeffizienten zu verhindern.

**12.** Bauteil nach Anspruch 3,
**dadurch gekennzeichne t, dass**
die Maskierungsschicht (25) zumindest teilweise kohlenstoffhaltig ist, insbesondere an ihrer äußeren

**14.** Bauteil nach Anspruch 3,
**dadurch gekennzeichnet , dass**
die Maskierungsschicht (25) eine Gradientenschicht ist.
